# EUROPEAN PATENT SPECIFICATION

(11) **EP 3 844 840 B1**
(45) Date of publication and mention of the grant of the patent: **28.12.2022**
(21) Application number: 19755893.5
(22) Date of filing: 15.08.2019
(51) Int. Cl.: H01P 1/22, H01P 1/203

(54) **PACKAGING AND THERMALIZATION OF CRYOGENIC DISPERSIVE-RESISTIVE HYBRID ATTENUATORS FOR QUANTUM MICROWAVE CIRCUITS**
EINHAUSUNG UND THERMALISIERUNG VON KRYOGENEN DISPERSIONSRESISTIVEN HYBRID-DÄMPFUNGSGLIEDERN FÜR QUANTEN-MIKROWELLENSCHALTUNGEN
EMPAQUETAGE ET THERMALISATION D'ATTÉNUATEURS HYBRIDES DISPERSIFS-RÉSISTIFS CRYOGÉNIQUES POUR CIRCUITS MICRO-ONDES QUANTIQUES

(30) Priority: 28.08.2018 US 201816114890; 28.08.2018 US 201816114793
(43) Date of publication of application: 07.07.2021
(73) Proprietor: International Business Machines Corporation, Armonk, New York 10504 (US)
(72) Inventor: GUMANN, Patryk, New York 10598 (US); ABDO, Baleegh, New York 10598 (US)
(74) Representative: Gascoyne, Belinda Jane
(86) International application number: PCT/EP2019/071958
(87) International publication number: WO 2020/043503

(56) References cited:
- JP-A- H07 312 508
- JP-A- 2009 124 072
- US-A- 5 502 421
- US-A1- 2009 231 068
- YEH JEN-HAO ET AL: "Microwave attenuators for use with quantum devices below 100 mK", JOURNAL OF APPLIED PHYSICS, AMERICAN INSTITUTE OF PHYSICS, US, vol. 121, no. 22, 8 June 2017 (2017-06-08) , XP012219504, ISSN: 0021-8979, DOI: 10.1063/1.4984894 [retrieved on 2017-06-08]

## Description

### TECHNICAL FIELD

The present invention relates generally to a device, a housing design method, and a construction system for a microwave frequency attenuator housing usable with superconducting qubits in quantum computing. More particularly, the present invention relates to a device, method, and system for packaging and thermalization of cryogenic dispersive-resistive hybrid attenuators for quantum microwave circuits.

### BACKGROUND

Hereinafter, a "Q" prefix in a word of phrase is indicative of a reference of that word or phrase in a quantum computing context unless expressly distinguished where used.

Molecules and subatomic particles follow the laws of quantum mechanics, a branch of physics that explores how the physical world works at the most fundamental levels. At this level, particles behave in strange ways, taking on more than one state at the same time, and interacting with other particles that are very far away. Quantum computing harnesses these quantum phenomena to process information.

The computers we use today are known as classical computers (also referred to herein as "conventional" computers or conventional nodes, or "CN"). A conventional computer uses a conventional processor fabricated using semiconductor materials and technology, a semiconductor memory, and a magnetic or solidstate storage device, in what is known as a Von Neumann architecture. Particularly, the processors in conventional computers are binary processors, i.e., operating on binary data represented in 1 and 0.

A quantum processor (q-processor) uses the odd nature of entangled qubit devices (compactly referred to herein as "qubit," plural "qubits") to perform computational tasks. In the particular realms where quantum mechanics operates, particles of matter can exist in multiple states-such as an "on" state, an "off state, and both "on" and "off" states simultaneously. Where binary computing using semiconductor processors is limited to using just the on and off states (equivalent to 1 and 0 in binary code), a quantum processor harnesses these quantum states of matter to output signals that are usable in data computing.

Conventional computers encode information in bits. Each bit can take the value of 1 or 0. These 1s and 0s act as on/off switches that ultimately drive computer functions. Quantum computers, on the other hand, are based on qubits, which operate according to two key principles of quantum physics: superposition and entanglement.

Superposition means that each qubit can represent both a 1 and a 0 at the same time. Entanglement means that qubits in a superposition can be correlated with each other in a non-classical way; that is, the state of one (whether it is a 1 or a 0 or both) can depend on the state of another, and that there is more information that can be ascertained about the two qubits when they are entangled than when they are treated individually.

Using these two principles, qubits operate as more sophisticated processors of information, enabling quantum computers to function in ways that allow them to solve difficult problems that are intractable using conventional computers. IBM ^{®} has successfully constructed and demonstrated the operability of a quantum processor using superconducting qubits (IBM is a registered trademark of International Business Machines corporation in the United States and in other countries.)

A superconducting qubit includes a Josephson junction. A Josephson junction is formed by separating two thin-film superconducting metal layers by a non-superconducting material. When the metal in the superconducting layers is caused to become superconducting - e.g. by reducing the temperature of the metal to a specified cryogenic temperature -pairs of electrons can tunnel from one superconducting layer through the non-superconducting layer to the other superconducting layer. In a qubit, the Josephson junction - which functions as a dispersive nonlinear inductor - is electrically coupled in parallel with one or more capacitive devices forming a nonlinear microwave oscillator. The oscillator has a resonance/transition frequency determined by the value of the inductance and the capacitance in the qubit circuit. Any reference to the term "qubit" is a reference to a superconducting qubit circuitry that employs a Josephson junction, unless expressly distinguished where used.

The information processed by qubits is carried or transmitted in the form of microwave signals/photons in the range of microwave frequencies. The microwave signals are captured, processed, and analyzed to decipher the quantum information encoded therein. A readout circuit is a circuit coupled with the qubit to capture, read, and measure the quantum state of the qubit. An output of the readout circuit is information usable by a q-processor to perform computations.

A superconducting qubit has two quantum states -|0> and |1>. These two states may be two energy states of atoms, for example, the ground (|g>) and first excited state (|e>) of a superconducting artificial atom (superconducting qubit). Other examples include spin-up and spin-down of the nuclear or electronic spins, two positions of a crystalline defect, and two states of a quantum dot. Since the system is of a quantum nature, any combination of the two states are allowed and valid.

For quantum computing using qubits to be reliable, quantum circuits (q-circuits), e.g., the qubits themselves, the readout circuitry associated with the qubits, and other parts of the quantum processor, must not alter the energy states of the qubit, such as by injecting or dissipating energy in any significant manner, or influence the relative phase between the |0> and |1> states of the qubit. This operational constraint on any circuit that operates with quantum information necessitates special considerations in fabricating semiconductor and superconducting structures that are used in such circuits.

The presently available superconducting quantum circuits are formed using materials that become superconducting at cryogenically low temperatures, e.g., at about 10-100 millikelvin (mK), or about 4 K. The electronic circuits that are used to control, operate, and measure the quantum circuits are usually located outside the dilution fridge that houses the superconducting quantum circuit. The temperature outside the fridge is usually about 300 K (room temperature).

The presently available superconducting quantum circuits usually operate in the microwave frequency range. Microwave signals/pulses are used to initialize, manipulate, control, and measure the superconducting qubits within the superconducting q-circuits. To communicate these microwave signals between the external electronic circuits outside the fridge and the superconducting quantum circuits inside the fridge, microwave transmission lines are used inside the dilution fridge. Coaxial lines are one example of transmission lines that can carry these microwave signals.

The presently available dilution fridges are cryogenic apparatus which can be used to cool down samples/devices to millikelvin temperatures. However, the transition from room temperature to millikelvin temperatures inside the fridge is not sudden or abrupt. To facilitate the temperature transition and the cooling operation, the dilution fridge consists of multiple thermally-isolated stages (compactly referred to herein as "stage", plural "stages") held at different ambient temperatures. For example, common commercial dilution fridges have 5 temperature-stages inside the fridge 40 K, 4 K, 0.7 K, 0.1 K, 0.01 K (also known as the base stage). To simplify the discussion, we focus below on the input lines inside the fridge. To maintain the temperature difference between the different stages inside the fridge and to protect the quantum circuits from noise coming down the input lines, which originates from room-temperature electronics or blackbody radiation of higher stages or other sources of electromagnetic noise, it is common practice to use lossy transmission lines to connect between two consecutive stages and to incorporate resistive attenuators and filters in the path of these lines at the different stages. In general, components serve multiple purposes: they attenuate/reduce the noise coming down these input lines, they attenuate/reduce microwave signals propagating in the lines, they provide thermal isolation between the stages, they cool down the microwave signals propagating through them.

A signal propagating on a line passing through a stage can contain noise, especially electromagnetic noise. This noise can be in the microwave frequency spectrum or infrared spectrum. For the reasons described herein, electronic, microwave and infrared noise are undesirable when the lines and signals relate to quantum computing using q-circuits.

Attenuation of a signal is the process of reducing the power of the signal at a particular frequency or frequency-range. An attenuator is an electronic circuit with two ports that is configured to attenuate an input signal/noise at a particular frequency or frequency-range.

A resistive attenuator attenuates a transmitted signal and/or noise by dissipating the energy of the signal and/or noise in a resistive component of the attenuator. A dispersive attenuator attenuates the transmitted signal/noise through its two ports by reflecting a portion of its energy/power off the port it entered through.

The illustrative embodiments recognize that commercially available standard microwave attenuators are either resistive or dispersive but not both. Furthermore, the illustrative embodiments recognize certain disadvantages with the presently available resistive microwave attenuators. For example, in most cases, the presently available resistive attenuators are formed such that a metallic case enclosing the substrate is stainless steel, which has poor thermal conductance. Additionally, the pins of the connectors located on either port of the resistive attenuator are mechanically pressed against the conductor on the substrate, which yields a bad thermal contact. The substrate is mechanically pushed against the body of the metallic case, which also yields a bad thermal contact. In addition, the substrate materials used for these attenuators have far from ideal thermal conductance.

The illustrative embodiments further recognize that disadvantageously, the lower the attenuation in a presently available resistive attenuator, the higher the thermal and electrical resistance between the center conductor of the attenuator and a corresponding external conductor of the attenuator (e.g., ground), formed by the metallic case of the attenuator. The illustrative embodiments recognize that presently, the presently available resistive attenuator provide a fixed attenuation across a wide band of frequencies and its attenuation level cannot be made to be frequency dependent (i.e., the attenuation level is fixed versus frequency). Furthermore, the presently available resistive attenuators dissipate the microwave power in the attenuator itself. Such absorptive attenuation can have several undesired results: (1) it could raise the temperature of the attenuator, especially if the attenuator is poorly thermalized to the stage, leading to reduced cooling of the microwave signals passing through it. (2) it could raise the temperature of the stage especially if it has many attenuators and limited cooling power. (3) it could generate elevated blackbody radiation towards the lower-temperature stages.

The illustrative embodiments recognize certain disadvantages with the presently available dispersive type of commercial microwave attenuators as well. They suffer from similar thermalization issues as resistive attenuators outlined above. In addition, they can cause multiple reflections of signals in the line, which, in turn, can cause distortions in the microwave pulses/signals, crosstalk, and ripples in the measured signals.

The illustrative embodiments recognize that for an attenuator to be effective and usable in cryogenic environments, and particularly with quantum computing apparatus, the attenuator has to be shielded from microwave interference. Microwave interference can come from a variety of sources; however, the illustrative embodiments recognize that poorly formed housing of attenuators can result in significant microwave interference with the signal being propagated through the attenuator. For example, a connection in the line is a contributor to microwave interference by causing signal reflections to occur in the line that connects through the connection. The higher the number of connections, the higher the number of the reflection points and other disturbances introduced by the connections.

The illustrative embodiments recognize that the microwave shielding should be done in conjunction with robust thermalization so that temperature differentials are minimized between the attenuator and the corresponding refrigeration stage. Thermalization of one structure to another structure is the process of constructing and coupling the two structures in such a way that the coupling achieves at least a threshold level of thermal conductivity between the two structures. Good thermalization, i.e., thermalization where the thermal conductivity between the thermally coupled structure exceeds the threshold level of required thermal conductivity.

The illustrative embodiments recognize that presently available cryogenic attenuators, while suitable to operate at cryogenic temperatures up to approximately 77 degrees Kelvin (K), are unsuitable for use with quantum computing circuits, which operate in temperature less than 1 degree Kelvin, down to 2 milli K. In the temperature ranges where quantum computing circuits operate, the presently available cryogenic attenuators exhibit poor thermal conductivity of the substrate, housing and microwave connectors. Furthermore, the presently available cryogenic attenuators employ microwave connectors of different genders, which produces a need for gender conversion adapters. The adapters in turn cause an increase in the number of reflection points in the microwave lines and add additional thermal mass which needs to be cooled down to milli K.

The illustrative embodiments recognize that in order to use an attenuator for control lines of a quantum processor, the attenuator should be embedded in specially designed housing which is thermally anchored to various parts of a dilution refrigerator stage. This thermal anchoring in presently available cryogenic attenuators is still unable to achieve a desirable level of thermalization even with the increased cost and labor involved in the anchoring. A need exists for a packaging and thermalization of cryogenic dispersive-resistive hybrid attenuators for quantum microwave circuits which provides a desirable level of thermalization at temperatures where quantum processors presently operate, while providing improved microwave hygiene through minimized reflections in microwave lines. "Suppressing on -chip electromagnetic crosstalk for spin qubit devices" (Blanvillain, S. et al. Journal of Applied Physics vol 112, number 6, 15 September 2012) discloses on-chip interconnects designed to suppress electromagnetic crosstalk in spin qubit device architectures with the large number of gate electrodes needed for multi-qubit operation. US Patent number 9 836 699 B1(Rigetti C. T. et al. "Microwave integrated quantum circuits with interposer", 5 December 2017) discloses a quantum computing apparatus, including a quantum circuit device; and an interposer including a connectorization layer including a plurality of terminals for connecting the quantum computing apparatus to a corresponding plurality of cables and a plurality of signal lines electrically coupled, via electrical contacts, to the plurality of terminals; and at least one intermediate layer between the quantum circuit device and the connectorization layer, the at least one intermediate layer comprising an integrated circuit layer, the at least one intermediate layer being electrically coupled to the signal lines of the interposer. The interposer is configured to supply the quantum circuit device, during operation of the quantum computing apparatus, at least control signals and readout signals to and from the plurality of cables. US Patent Application Publication US 2009/0231068 A1 Das, A. et al ("Filter-Attenuator Chip Device", 17 September 2009) discloses a microchip device that combines a signal attenuator and a frequency filter. An embodiment of the device includes an input contact, an output contact, and a ground contact formed on the surface of a substrate. Resistive elements formed on the substrate interconnect the contacts. At least the input contact includes a gap pattern formed therein that is dimensioned and arranged such that the input contact provides a reactive impedance characteristic. The combination of the resistance of the resistive elements and the reactive impedance characteristic of the input contact are selected to provide attenuation and frequency filtering of a high frequency signal input to the microchip device. A method of manufacturing the filter-attenuator microchip device is also described.

Therefore, there is a need in the art to address the aforementioned problem.

### SUMMARY

Viewed from a first aspect, the present invention provides a hybrid microwave attenuator according to claim 1, wherein further advantageous modifications are defined in the dependent claims.

Viewed from a further aspect, the present invention provides a method according to claim 10, wherein further advantageous modifications are defined in the dependent claims.

### BRIEF DESCRIPTION OF THE DRAWINGS

The novel features believed characteristic of the invention are set forth in the appended claims. The invention itself, however, as well as a preferred mode of use, further objectives and advantages thereof, will best be understood by reference to the following detailed description of the illustrative embodiments when read in conjunction with the accompanying drawings, wherein:
**Figure 1** depicts a block diagram of an example configuration of an input line conditioning for quantum computing devices in accordance with an illustrative embodiment;
**Figure 2** depicts an example of presently available resistive microwave attenuator which can be used as a component in a hybrid attenuator in accordance with an illustrative embodiment;
**Figure 3** depicts one example configuration of a hybrid attenuator in accordance with an illustrative embodiment;
**Figure 4** depicts an example circuit implementing a hybrid attenuator in accordance with an illustrative embodiment;
**Figure 5** depicts microwave simulation results of the scattering parameters of a hybrid attenuator example;
**Figure 6** depicts another example configuration of a hybrid attenuator in accordance with an illustrative embodiment;
**Figure 7** depicts an example circuit implementing a hybrid attenuator in accordance with an illustrative embodiment;
**Figure 8** depicts microwave simulation results of the scattering parameters of a hybrid attenuator example; and
**Figure 9** depicts a rendering of an example packaging or housing for a hybrid attenuator in accordance with an illustrative embodiment.

### DETAILED DESCRIPTION

Quantum computing involves reliably reading microwave emissions of the order of a single photon. A low microwave noise environment limits microwave noise to such a threshold level so as to allow reliable reading of microwave emissions of the order of a single photon. The illustrative embodiments used to describe the invention generally address and solve the above-described needs for low microwave noise and well thermalized packaging or housing for attenuating certain microwave signals mainly in the input lines connecting to q-circuits. The illustrative embodiments provide such packaging and thermalization of cryogenic dispersive-resistive hybrid attenuators for quantum microwave circuits, which address the above-described need or problem.

The illustrative embodiments recognize that performance of any superconducting based quantum architecture is heavily depended on the quality of the superconducting qubits themselves which can be directly characterized by the measuring coherence times. These times strongly depend on the performance of microwave hardware - not only the qubits themselves but also the attenuators used in the microwave lines and the housing for the attenuators - at temperature range where quantum computing circuits operate. In order to increase the coherence times, thus improve the functionality of the quantum processors, all the microwave components, control lines, components, and packaging are designed for microwave noise minimization and thermalized to a quantum computing-acceptable level of thermalization.

The illustrative embodiments allow for better and faster thermalization of the microwave components and cleaner microwave signal throughput, by utilizing an attenuator design, packaging design, fabrication materials for the attenuator, and high thermal conductivity materials in the fabrication of the packaging, as described herein. Several embodiments describing various designs of the proposed hybrid attenuator are presented with respect to several figures first. Thereafter, several embodiments describing a low noise well thermalized packaging for a hybrid attenuator of an embodiment are presented.

An operation described herein as occurring with respect to a frequency of frequencies should be interpreted as occurring with respect to a signal of that frequency or frequencies. All references to a "signal" are references to a microwave signal unless expressly distinguished where used.

An embodiment provides a configuration of a hybrid microwave attenuator that exhibits both resistive characteristics as well as dispersive characteristics (interchangeably referred to herein as a "hybrid attenuator"). Another embodiment provides a design/construction method for the hybrid attenuator, such that the method can be implemented as a software application. The application implementing a design/construction method embodiment can be configured to operate in conjunction with an existing circuit manufacturing system - such as a circuit assembly system.

For the clarity of the description, and without implying any limitation thereto, the illustrative embodiments are described using some example configurations. From this disclosure, those of ordinary skill in the art will be able to conceive many alterations, adaptations, and modifications of a described configuration for achieving a described purpose, and the same are contemplated within the scope of the illustrative embodiments.

Furthermore, simplified diagrams of the example resistors, inductors, capacitors, and other circuit components are used in the figures and the illustrative embodiments. In an actual circuit, additional structures or component that are not shown or described herein, or structures or components different from those shown but for a similar function as described herein may be present without departing the scope of the illustrative embodiments.

Furthermore, the illustrative embodiments are described with respect to specific actual or hypothetical components only as examples. The steps described by the various illustrative embodiments can be adapted for fabricating a circuit using a variety of components that can be purposed or repurposed to provide a described function within a hybrid attenuator, and such adaptations are contemplated within the scope of the illustrative embodiments.

The illustrative embodiments are described with respect to certain types of materials, electrical properties, steps, numerosity, frequencies, circuits, components, and applications only as examples. Any specific manifestations of these and other similar artifacts are not intended to be limiting to the invention. Any suitable manifestation of these and other similar artifacts can be selected within the scope of the illustrative embodiments.

The examples in this disclosure are used only for the clarity of the description and are not limiting to the illustrative embodiments. Any advantages listed herein are only examples and are not intended to be limiting to the illustrative embodiments. Additional or different advantages may be realized by specific illustrative embodiments. Furthermore, a particular illustrative embodiment may have some, all, or none of the advantages listed above.

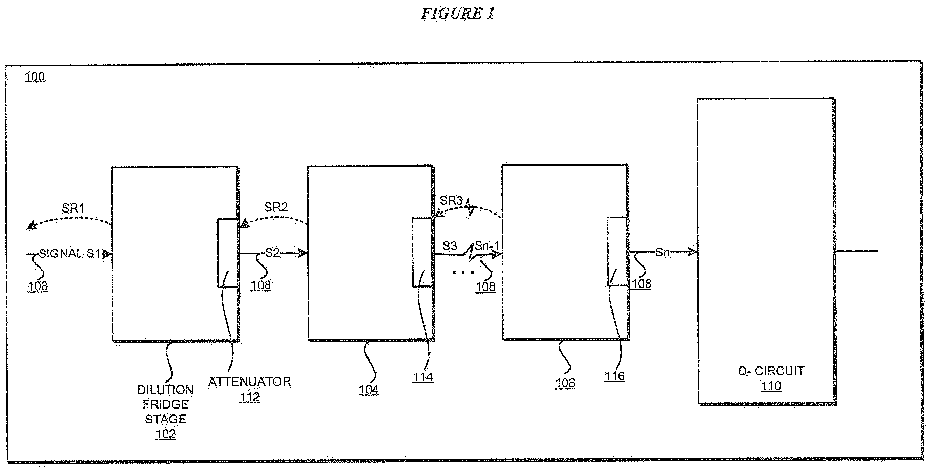

With reference to **Figure 1****,** this figure depicts a block diagram of an example configuration of an input line conditioning for quantum computing devices in accordance with an illustrative embodiment. Configuration **100** comprises a set of one or more dilution fridge stages **102, 104, ...106.** Input line **108** connects an external circuit to q-circuit **110.** Assuming that line **108** carries a microwave signal to q-circuit **110,** signal S₁ is a signal which includes microwave noise that is to be attenuated along with the signal S₁. Signal Sₙ is the attenuated signal that reaches q-circuit **110.**

One embodiment configures a hybrid attenuator with some but not all of stages **102-106.** Another embodiment configures a hybrid attenuator with each of stages **102-106,** as shown in **Figure 1****.** For example, hybrid attenuator **112** is configured to operate with stage **102.** Hybrid attenuator **112** receives input signal S₁ and reflected signal S_{R2} from subsequent stages in the series of stages. Hybrid attenuator **112** attenuates one frequency or frequency band from the (S₁+S_{R2}) signal to produce signal S₂.

Hybrid attenuator **114** is configured to operate with stage **104.** Hybrid attenuator **114** receives input signal S₂ and reflected signal S_{R3} from subsequent stages in the series of stages. Hybrid attenuator **114** attenuates a different frequency or frequency band from the (S₂+S_{R3}) signal to produce signal S₃. Operating in this manner, stage **106** (stage n) has hybrid attenuator **116** configured therewith. Hybrid attenuator **116** receives input signal Sₙ₋₁ (and possibly a reflected signal if q-circuit **110** is configured to reflect any signal frequencies, not shown) from previous stages in the series of stages. Hybrid attenuator **116** attenuates a different frequency or frequency band from the (Sₙ₋₁ + any reflected frequencies) signal to produce signal Sₙ, which forms an input to q-circuit **110.**

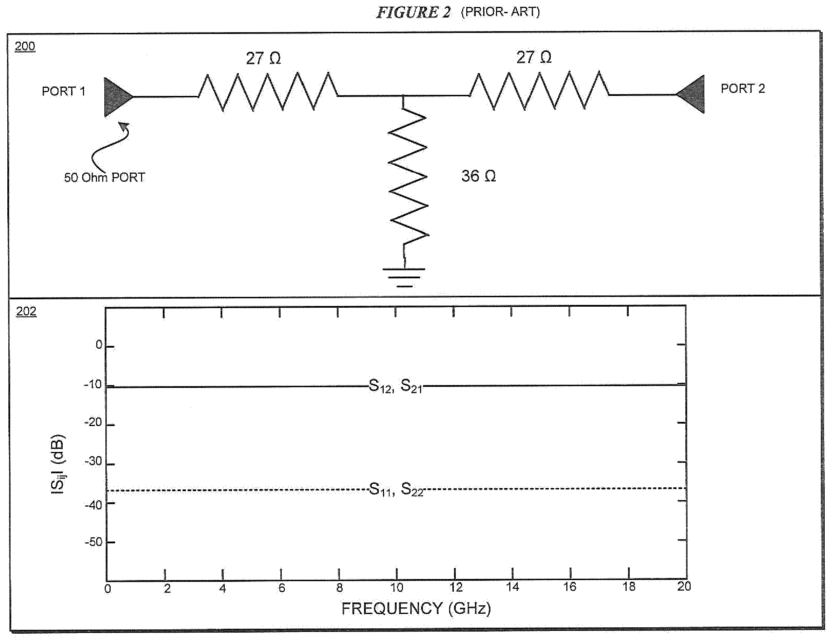

With reference to **Figure 2****,** this figure depicts an example of presently available resistive microwave attenuator which can be used as a component in a hybrid attenuator in accordance with an illustrative embodiment. Circuit **200** implements an example 10-dB lumped-element resistive attenuator that is formed using a T-configuration between ports 1 and 2, (i.e., two equal series resistors connected in the middle by one resistor to ground). In microwave engineering terminology, S₁₂ represents the scattering parameter for a signal entering port 2 and exiting through port 1 (i.e., transmission from port 2 to 1). Similarly, S₂₁ represents the scattering parameter for a signal entering port 1 and exiting through port 2. S₁₁ and S₂₂ represent the reflection parameters of signals entering ports 1 and 2, respectively.

Graph **202** depicts microwave simulation results of the scattering parameters of resistive attenuator **200.** As can be seen in graph **202,** transmitted signals through the device (represented by the amplitude of the scattering parameters S₂₁ and S₁₂) are attenuated by about 10 dB over a large bandwidth. The device is also well matched to 50 Ohms on both ports as shown by the negligible amplitude of the reflection parameters S₁₁ and S₂₂. This means that there is almost no reflection off the device ports. The lost energy of the transmitted signals is dissipated as heat within the resistors of the circuit **200.**

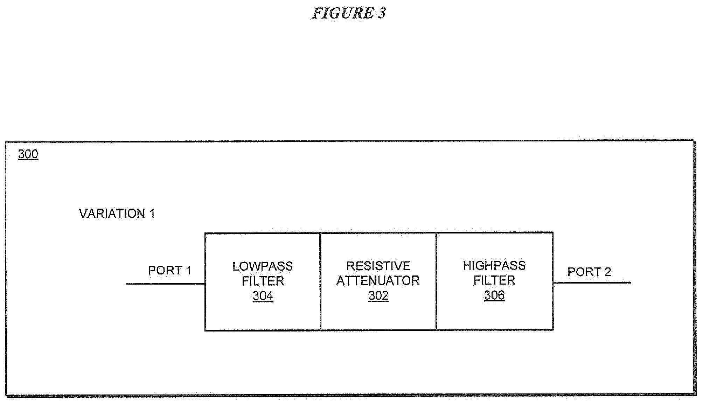

With reference to **Figure 3****,** this figure depicts one example configuration of a hybrid attenuator in accordance with an illustrative embodiment. The example configuration in this figure - variation 1 - of hybrid attenuator **300** comprises resistive attenuator **302,** lowpass filter **304,** and high-pass filter **306.** The components can be arranged in a variety of arrangements within the scope of the illustrative embodiments. For example, one arrangement may be **304-302-306** in that order as shown (i.e., lowpass filter **304,** followed by resistive attenuator **302,** followed by high-pass filter **306).** Other arrangements may be **302-304-306, 304-306-302, 306-302-304, 306-304-302,** and others possible arrangements in a similar manner.

Hybrid attenuator **300** is a dispersive-resistive attenuator and can be implemented as a two-port integrated circuit. Lowpass filter **304** is a dispersive filter to filter out a frequency band that is higher than a threshold frequency (and passes a frequency band that is lower than a threshold frequency). Resistive attenuator **302** is resistive or absorptive filter that operates in the manner of resistive attenuator **200** in **Figure 2****.** High-pass filter **306** is a dispersive filter to filter out a frequency band that is lower than a threshold frequency (and passes a frequency band that is higher than a threshold frequency). According to one embodiment, a circuit assembly system forms and connects the three components - **302, 304,** and **306** on the same chip or printed circuit board.

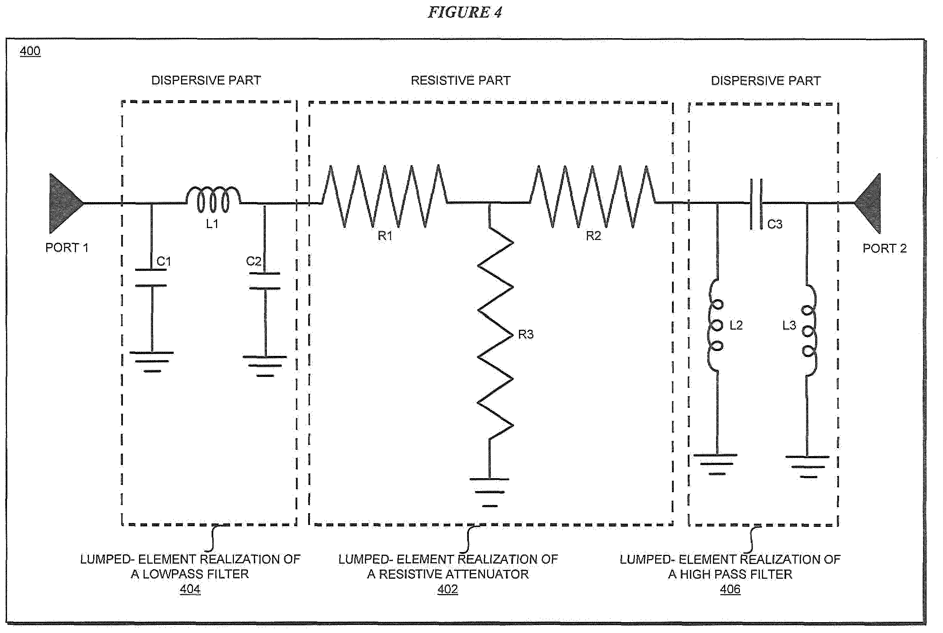

With reference to **Figure 4****,** this figure depicts an example circuit implementing a hybrid attenuator in accordance with an illustrative embodiment. Component **402** is a resistive element which implements a resistive attenuator, i.e., component **302** of **Figure 3****.** Component **404** is a dispersive element which implements a lowpass filter, i.e., component **304** of **Figure 3****.** Component **406** is a dispersive element which implements a high-pass filter, i.e., component **306** of **Figure 3****.**

Component **402** comprises a T-configuration of resistor elements R1, R2, and R3, as in Figure 2. Note that the depiction of component **402** and resistors R1, R2, and R3 are lumped realizations, i.e., a representation of an effective function of component **402** as a resistive attenuator in the microwave frequency band. An equivalent pi-configuration of this component exists and is interchangeable with the depicted non-limiting example configuration.

Component **404** comprises a pi-arrangement of capacitive elements C1 and C2 coupled to ground, i.e., the external conductor of the hybrid attenuator, on one side and to inductive element L1 via the center conductor of the hybrid attenuator on the other side, as shown. The depiction of component **404** and elements C1, C2, and L1 are lumped realizations, i.e., a representation of an effective function of component **404** as a lowpass filter in the microwave frequency band. This example shows a simple one-unit-cell, low-pass filter. This design also covers the cases in which the simple low-pass filter shown in **Figure 4** is replaced by a more sophisticated low-pass filter that consists of several unit cells and whose attenuation, transmission, bandwidth, cutoff frequency and ripples characteristics are optimized further or differently.

Component **406** comprises a pi-arrangement of inductive elements L2 and L3 coupled to ground, i.e., the external conductor of the hybrid attenuator, on one side and to capacitive element C3 via the center conductor of the hybrid attenuator on the other side, as shown. The depiction of component **406** and elements L2, L3, and C3 are lumped realizations, i.e., a representation of an effective function of component **406** as a high-pass filter in the microwave frequency band. This example shows a simple one-unit-cell, high-pass filter. This design also covers the cases in which the simple high-pass filter shown in **Figure 4** is replaced by a more sophisticated high-pass filter that consists of several unit cells and whose attenuation, transmission, bandwidth, cutoff frequency and ripples characteristics are optimized further or differently.

In component **406,** capacitive element C3 on the center conductor of the hybrid attenuator serves as a direct current (DC) block which can be used to eliminate the formation of ground loops in the fridge. Such ground loops are undesirable as they can generate electronic noise. Additionally, inductive elements L2 and L3 offer a path of negligible resistance between the center conductor and the external conductor of the hybrid attenuator. Such low-resistance, electrical-thermal paths can significantly improve the thermalization of the center conductor of the hybrid attenuator compared to the case of the resistive attenuator alone, where the center conductor is thermally isolated from ground (the attenuator housing) by a considerable electrical-thermal resistance.

To facilitate low microwave noise, high thermalization, or both, various embodiments effectuate the fabrication of hybrid attenuator **400** in a variety of ways using lumped elements as shown and described herein. One embodiment fabricates components **402, 404,** and **406** on a single chip using semiconductor fabrication methods on a substrate of a wafer. Another embodiment fabricates components **402, 404,** and **406** using circuit assembly methods on a printed circuit board (PCB) to integrate electrical and electronic elements to form components **402, 404,** and **406** on the same PCB.

To form the lumped element realization of components **402, 404,** and **406,** one embodiment fabricates an inductor, e.g., inductive elements L1, L2, and/or L3 using a metal that exhibits a Residual Resistance Ratio (RRR) of at least 100, and a thermal conductivity of greater than a 1 W/(cm*K) at 4 Kelvin, threshold level of thermal conductivity. RRR is the ratio of the resistivity of a material at room temperature and at 0 K. Because 0 K cannot be reached in practice, an approximation at 4 K is used. Furthermore, because different stages operate in different temperature ranges, the material selection for the inductive elements also differs from one lumped realization to another, depending on the stage - and thermal range - in which the lumped realization will be operating. Some non-limiting examples of metals usable for the inductive elements include Aluminum and Brass for operations in the temperature range of 300K to 2K. Some non-limiting examples of metals usable for the inductive elements include oxygen-free high-conductivity copper, electrolytic copper, gold, platinum, or silver for operations in the temperature range of 2K to 0.000001K.

To form the lumped element realization of components **402, 404,** and **406,** one embodiment fabricates a capacitor, e.g., capacitive elements C1, C2, and/or C3 using a dielectric material that exhibits an RRR of at least 100, and plates having a thermal conductivity of greater than a 1 W/(cm*K)at 4 Kelvin threshold level of thermal conductivity. Some non-limiting examples of materials usable for the dielectric of the capacitive elements include Silicon Nitride (SiN), Crystalline Silicon, and amorphous Silicon.

To form the lumped element realization of components **402, 404,** and **406,** one embodiment fabricates a resistor, e.g., resistive elements R1, R2, and/or R3 using a thin film of resistive metals. In one embodiment, the thickness of the thin film is below a threshold thickness, e.g., 100 nm, and some non-limiting examples of metals usable to form the thin-film resistive elements include NiCr, TaNₓ (nickel-chrome, talinum-nitrate).

To fabricate hybrid attenuator **400** in one or the above-described manner, an embodiment uses a substrate material that exhibits high thermal conductivity at low temperatures. In one embodiment, the thermal conductivity of substrate is at least equal to or greater than a threshold level of thermal conductivity, e.g., 0.1 W/(cm*K)at 4 Kelvin, in a temperature range, e.g. 4-300 K. some non-limiting examples of materials usable to form the substrate include Silicon, Gallium Arsenide (GaAs), sapphire, quartz, and fused silica.

The lumped realizations of components **402, 404,** and **406** are not intended to be limiting. From this disclosure, those of ordinary skill in the art will be able to conceive many other implementations for a depicted lumped realization, e.g., using additional or different elements to achieve a similar function of the lumped realization shown here, and such implementations are contemplated within the scope of the illustrative embodiments.

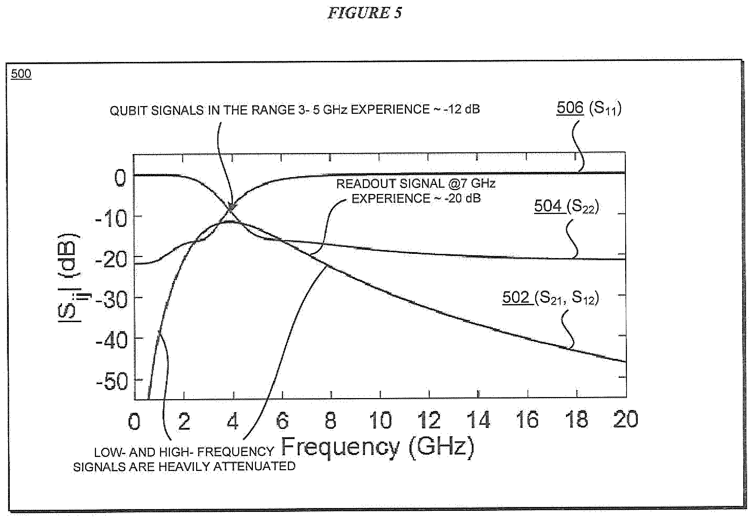

With reference to **Figure 5****,** this figure depicts microwave simulation results of the scattering parameters of a hybrid attenuator example. The hybrid attenuator circuit, whose scattering parameters are shown in **Figure 5****,** is based on the lumped-element circuit **400** exhibited in **Figure 4****.** Specifically, in the non-limiting example implementation, R1 and R2 were each set to 27 Ohms, R3 was set to 36 Ohms, L1 was set to 3.18 nanohenry (nH), C1 and C2 were each set to 0.64 picofarad (pF), L2 and L3 were each set to 2.65 nH, and C3 was set to 0.53 pF.

In Figure 5, the graph **502** represents the transmission parameters S₂₁ and S₁₂, while the graphs **506** and **504** represent the reflection parameter S₁₁ and S₂₂, respectively. Graph **502** shows significant attenuation for transmitted signals above (e.g., 20 dB at 7 GHz) and below (e.g., 20 dB around 2 GHz) the superconducting qubit frequency range (e.g., 3-5 GHz), while allowing the signals in the qubit signal range to pass moderately attenuated (i.e., attenuated by about 10 dB).

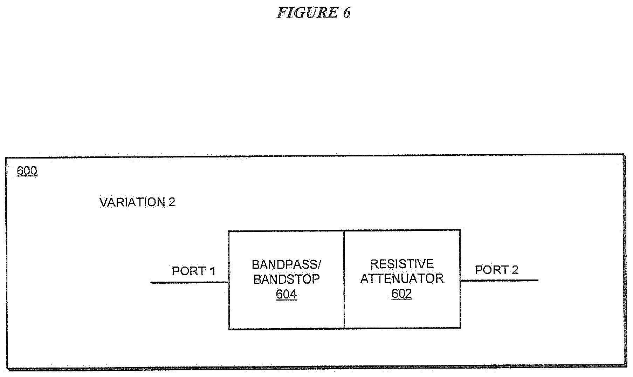

With reference to **Figure 6****,** this figure depicts another example configuration of a hybrid attenuator in accordance with an illustrative embodiment. The example configuration in this figure - variation 2 - of hybrid attenuator **600** comprises resistive attenuator **602** and bandpass (or bandstop) filter **604.** The components can be arranged in a variety of arrangements within the scope of the illustrative embodiments. For example, one arrangement may be **604-602** in that order as shown (i.e., bandpass filter **604,** followed by resistive attenuator **602).** Other arrangements may be **602-604, 604-602-604** for different frequency bands, and others possible arrangements in a similar manner.

Hybrid attenuator **600** is a dispersive-resistive attenuator and can be implemented as a two-port integrated circuit. Bandpass filter **604** is a dispersive filter to allow a frequency band that is between two threshold frequencies (and attenuates/blocks frequencies outside this pass band). Resistive attenuator **602** is resistive or absorptive filter that operates in the manner of resistive attenuator **302** in **Figure 3****.** According to one embodiment, a circuit assembly system forms and connects together the two components - **602 and 604** on the same chip or printed circuit board.

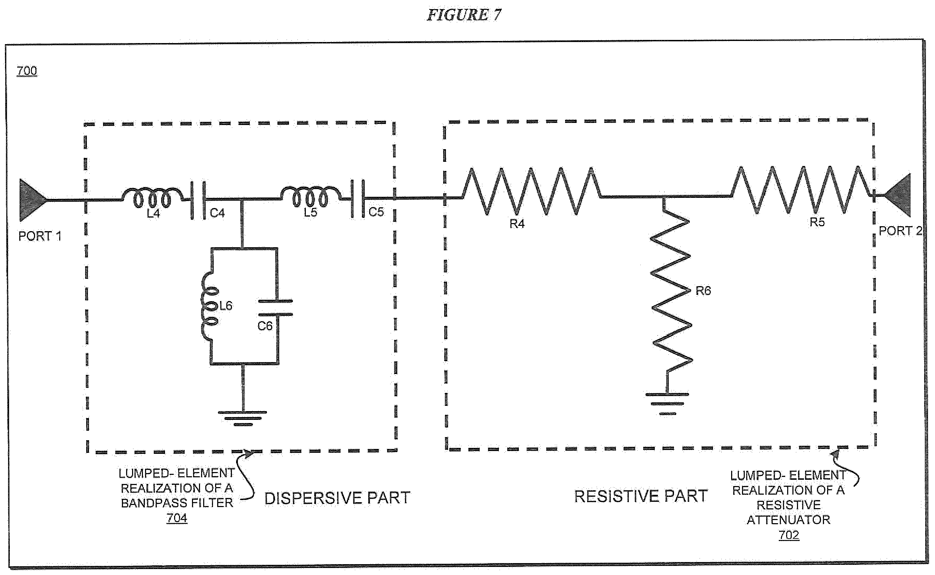

With reference to **Figure 7****,** this figure depicts an example circuit implementing a hybrid attenuator in accordance with an illustrative embodiment. Component **702** is a resistive element which implements a resistive attenuator in a manner similar to component **302** of **Figure 3****.** Component **704** is a dispersive element which implements a bandpass filter which replaces components **304** and **306** of **Figure** 3 and plays a similar role.

Component **702** comprises a T-configuration of resistor elements R4, R5, and R6, as in **Figure 2****.** Note that the depiction of component **702** and resistors R4, R5, and R6 are lumped realizations, i.e., a representation of an effective function of component **702** as a resistive attenuator in the microwave frequency band.

Component **704** comprises a configuration of capacitive elements L6 and C6 in parallel and coupled to ground, i.e., the external conductor of the hybrid attenuator on one side. L6-C6 couple to L4-C4 series and L5-C5 series via an internal conductor of the hybrid attenuator on the other side, as shown. The depiction of component **704** and elements L4-L6 and C4-C6 are lumped realizations, i.e., a representation of an effective function of component **704** as a bandpass filter in the microwave frequency band. This example shows a simple one-unit-cell, bandpass filter. This design also covers the cases in which the simple bandpass filter shown in **Figure 7** is replaced by a more sophisticated bandpass filter that consists of several unit cells and whose attenuation, transmission, bandwidth, cutoff frequency and ripples characteristics are optimized further or differently.

In component **704,** capacitive elements C4 and C5 on the internal conductor of the hybrid attenuator serve as DC blocks, which can be used to eliminate the formation of ground loops in the fridge. Such ground loops are undesirable as they can generate electronic noise. Inductive element L6 connecting the center and external conductors of the hybrid attenuator offers a path of negligible resistance between the center conductor and the external conductor of the hybrid attenuator. Such low-resistance, electrical-thermal paths can significantly improve the thermalization of the center conductor of the hybrid attenuator compared to the case of the resistive attenuator alone, where the center conductor is thermally isolated from ground (the attenuator case) by a considerable electrical-thermal resistance.

To facilitate low microwave noise, high thermalization, or both, various embodiments effectuate the fabrication of hybrid attenuator **700** in a manner similar to the embodiments described with respect to hybrid attenuator **400** in **Figure 4****.** One embodiment fabricates components **702** and **704** on a single chip using semiconductor fabrication methods on a substrate of a wafer. Another embodiment fabricates components **702** and **704** using circuit assembly methods on a printed circuit board (PCB) to integrate electrical and electronic elements to form components **702** and **704** on the same PCB.

To form the lumped element realization of components **702** and **704,** one embodiment fabricates an inductor, e.g., inductive elements L4, L5, and/or L6 using materials and techniques described with respect to inductive elements L1, L2, or L3 in **Figure 4****.** Similarly, an embodiment fabricates a capacitor, e.g., capacitive elements C4, C5, and/or C6 using materials and techniques described with respect to capacitive elements C1, C2, or C3 in **Figure 4****.** An embodiment fabricates a resistor, e.g., resistive elements R4, R5, and/or R6 using materials and techniques described with respect to resistive elements R1, R2, or R3 in **Figure 4****.** When a substrate is used for fabricating lumped realizations **702** and **704,** an embodiment uses a material for the substrate as described with respect to **Figure 4****.**

The lumped realizations of components **702** and **704 406** are not intended to be limiting. From this disclosure, those of ordinary skill in the art will be able to conceive many other implementations for a depicted lumped realization, e.g., using additional or different elements to achieve a similar function of the lumped realization shown here, and such implementations are contemplated within the scope of the illustrative embodiments.

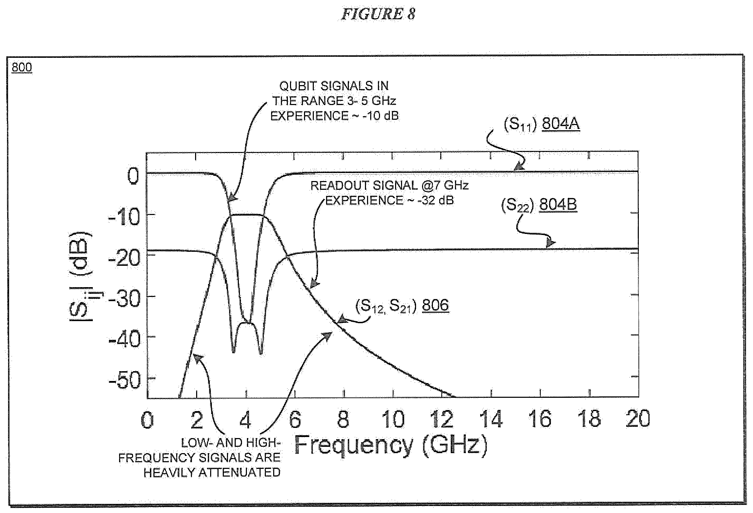

With reference to **Figure 8****,** this figure depicts microwave simulation results of the scattering parameters of a hybrid attenuator example. The hybrid attenuator circuit, whose scattering parameters are shown in **Figure 8****,** is based on the lumped-element circuit **700** exhibited in **Figure 7****.** Specifically, in the non-limiting example implementation, R4 and R5 were each set to 27 Ohms, R6 was set to 36 Ohms, L4 and L5 were each set to 3.98 nH, C4 and C5 were each set to 0.398 pF, L6 was set to 0.497 nH, and C6 was set to 3.18 pF.

Graphs **804A** and **804B** represent the reflection parameter S₁₁ and S₂₂, respectively, for the example hybrid attenuator configuration shown in **Figure 7****.** Graph **804A** exhibits significant reflection outside the frequency range of qubit signals, which is approximately 3 to 5 GHz. Whereas, graph **804B** exhibits good matching to 50 Ohm (i.e., the characteristic impedance of the external ports of the hybrid attenuator) in the qubit frequency range.

Graph **806** represents the transmission parameters S₂₁ and S₁₂ for the example hybrid attenuator shown in **Figure 7****.** Graph **806** shows significant attenuation above and below the qubit frequency range. Component **702** with the bandpass filter **704** configuration produced a low level attenuation of approximately -10 to -12 decibels (dB) in the range of qubit signals, which is approximately 3 to 5 GHz in input signals, thus passing the qubit signals with relatively small attenuation while suppressing noise and signals outside the qubit range. Such a moderate attenuation of qubit signals might be useful when the duration of the quantum gates decreases with higher powers for qubit pulses (e.g., cross-resonance gates).

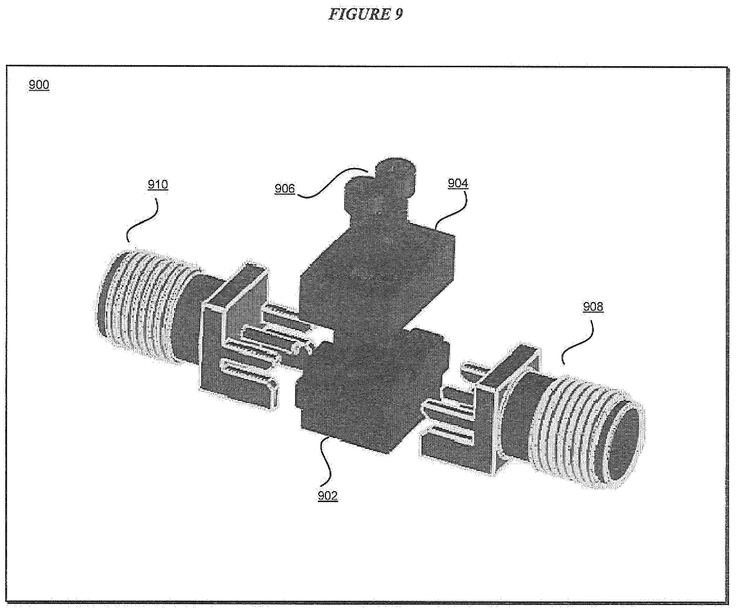

With reference to **Figure 9****,** this figure depicts a rendering of an example packaging or housing for a hybrid attenuator in accordance with an illustrative embodiment. Housing **900** is a non-limiting example configuration of a housing for a cryogenic resistive-dispersive hybrid attenuator. Housing **900** exhibits high thermalization with an associated stage, minimizes the generation and introduction of microwave reflections in the line connecting through the hybrid attenuator housed within (not visible), and is usable in one or more temperature range at which quantum processing circuits or portions thereof operate. Housing **900** is formed from a high-thermal conductivity material e.g., a material that exhibits thermal conductivity which meets or exceeds a threshold thermal conductivity level of 1 Watt/Kelvin-centimeter.

Housing **900** comprises base **902** which includes the space in which the hybrid attenuator can be fabricated, situated, or otherwise installed. Housing **900** further comprises cover **904.** Cover **904** is configured to fully cover an opening (not shown) in base **902,** where the opening is usable for installing the attenuator into base **902.** Cover **904** is thermally fastened, clamped, or otherwise thermally coupled with base **902** in such a manner that base **902** and cover **904** are well thermalized to one another, i.e., the combination of base **902** and cover **904** is thermally at the same temperature when coupled together.

One non-limiting example manner of fastening cover **904** to base **902** for acceptable thermalization in quantum computing temperature range is depicted in **Figure 9****.** One or more screws **906** fabricated from a material that exhibits thermal conductivity above a threshold level of thermal conductivity thermally contact cover **904** as well as base **902** to thermalize cover **904** to base **902.** Brass is one non-limiting example of material usable for fabricating screws **906.** This example of fastening for thermalization is not intended to be limiting. From this disclosure, those of ordinary skill in the art will be able to conceive many other methods of fastening for good thermalization and the same are contemplated within the scope of the illustrative embodiments. For example, in place of screws **906,** cover **904** can be bonded to base **902** using a thermally conductive bonding agent that exhibits thermal conductivity above the threshold level of thermal conductivity.

Housing **900** further comprises connectors **908** and **910.** Connectors **908** and **910** are specifically configured for usability with signals in the microwave frequency range. In accordance with an illustrative embodiment, connectors **908** and **910** are selected to be of the same type and gender. For example, connectors **908** and **910** can both be SubMiniature version A (SMA) type connectors of the female type such that connecting a microwave cable to housing **900** (and thereby to the hybrid attenuator **400** or **700** within housing **900)** does not require a gender conversion adapter. Using the same type and gender of connectors **908** and **910** thus minimizes microwave signal reflection that would otherwise arise from gender conversion adapters.

Furthermore, a material or a combination of materials used for connectors **908** and **910** should exhibit high thermal conductivity (above a threshold) as well as high electrical conductivity (above a threshold electrical conductivity or below a threshold resistance). One such non-limiting combination of materials is brass with gold plating to form connectors **908** and **910.** In one non-limiting embodiment, the threshold electrical conductivity is comparable to the electrical conductivity of copper or copper alloy used in manufactured electrical wiring, measured at room temperature.

These examples of the types, genders, and material-combinations of connectors **908** and **910** are not intended to be limiting. From this disclosure, those of ordinary skill in the art will be able to conceive many other types, genders, and material-combinations of microwave connectors and the same are contemplated within the scope of the illustrative embodiments. For example, miniature coaxial (MCX) or micro-miniature coaxial (MMCX) connectors, or many other types of microwave and radio frequency connectors, of the same gender, and of a suitable material or material combination, can be formed and used as connectors **908** and **910** within the scope of the illustrative embodiments.

Furthermore, connectors **908** and **910** may be fastened to microwave cables using any suitable manner of fastening. The depicted non-limiting example shows screw-type threaded connectors **908** and **910** to which a corresponding male end of a microwave cable can be threaded on. Without departing the scope of the illustrative embodiments, a press-fit or friction coupling type connectors can be used as connectors **908** and **910** so long as such connectors are of the same gender and are formed to satisfy the thermal conductivity and electrical conductivity requirements described herein.

Various embodiments of the present invention are described herein with reference to the related drawings. Alternative embodiments can be devised without departing from the scope of this invention. Although various connections and positional relationships (e.g., over, below, adjacent, etc.) are set forth between elements in the following description and in the drawings, persons skilled in the art will recognize that many of the positional relationships described herein are orientation-independent when the described functionality is maintained even though the orientation is changed. These connections and/or positional relationships, unless specified otherwise, can be direct or indirect, and the present invention is not intended to be limiting in this respect. Accordingly, a coupling of entities can refer to either a direct or an indirect coupling, and a positional relationship between entities can be a direct or indirect positional relationship. As an example of an indirect positional relationship, references in the present description to forming layer "A" over layer "B" include situations in which one or more intermediate layers (e.g., layer "C") is between layer "A" and layer "B" as long as the relevant characteristics and functionalities of layer "A" and layer "B" are not substantially changed by the intermediate layer(s).

The following definitions and abbreviations are to be used for the interpretation of the claims and the specification. As used herein, the terms "comprises," "comprising," "includes," "including," "has," "having," "contains" or "containing," or any other variation thereof, are intended to cover a non-exclusive inclusion. For example, a composition, a mixture, process, method, article, or apparatus that comprises a list of elements is not necessarily limited to only those elements but can include other elements not expressly listed or inherent to such composition, mixture, process, method, article, or apparatus.

Additionally, the term "illustrative" is used herein to mean "serving as an example, instance or illustration." Any embodiment or design described herein as "illustrative" is not necessarily to be construed as preferred or advantageous over other embodiments or designs. The terms "at least one" and "one or more" are understood to include any integer number greater than or equal to one, i.e. one, two, three, four, etc. The terms "a plurality" are understood to include any integer number greater than or equal to two, i.e. two, three, four, five, etc. The term "connection" can include an indirect "connection" and a direct "connection."

References in the specification to "one embodiment," "an embodiment," "an example embodiment," etc., indicate that the embodiment described can include a particular feature, structure, or characteristic, but every embodiment may or may not include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described.

The terms "about," "substantially," "approximately," and variations thereof, are intended to include the degree of error associated with measurement of the particular quantity based upon the equipment available at the time of filing the application. For example, "about" can include a range of ± 8% or 5%, or 2% of a given value.

The descriptions of the various embodiments of the present invention have been presented for purposes of illustration, but are not intended to be exhaustive or limited to the embodiments disclosed. Many modifications and variations will be apparent to those of ordinary skill in the art without departing from the scope of the invention defined by the appended claims.

## Claims

1. A hybrid microwave attenuator configured to operate in a temperature range of a refrigeration stage, the attenuator comprising:
a circuit having two ports (Port 1, Port 2), the circuit comprising:
a resistive component (302) configured to attenuate a plurality of frequencies in an input signal, and
a dispersive component (304, 306, 404, 406, 604, 704) configured to attenuate a second plurality of frequencies within a frequency range, wherein the resistive component and the dispersive component are arranged in a series configuration relative to one another between the two ports of the circuit, **characterized in that**:
the dispersive component comprising an inductive element (L2, L3, L6) configured to provide an electrical-thermal path between a center conductor of the hybrid microwave attenuator and a ground of the hybrid microwave attenuator, the inductive element being formed of a first material that exhibits at least a first threshold level of therma conductivity, wherein the first threshold level of thermal conductivity is achieved at a cryogenic temperature range in which a quantum circuit operates; and
a housing (900), the housing comprising:
a closable structure (902, 904, 906) in which the circuit is positioned, the structure being formed of a second material that exhibits at least a second threshold level of thermal conductivity, wherein the second threshold level of thermal conductivity is achieved at the cryogenic temperature range; and
a pair of microwave connectors (908, 910), the pair of connectors thermally coupled to the housing.

2. The hybrid microwave attenuator of claim 1, wherein the
inductive element (L2, L3, L6) is formed of the first material that exhibits an electrical conductivity of greater than a first threshold electrical conductivity when operating in the temperature range.

3. The hybrid microwave attenuator of claim 2, wherein the temperature range is bound by 300 degrees Kelvin, K, and 2 K.

4. The hybrid microwave attenuator of claim 2, wherein the temperature range is bound by 2 K and 0.000001 K.

5. The hybrid microwave attenuator of any of the preceding claims, the dispersive component further comprising:
a capacitive element (C1, C2, C3, C4, C5, C6) comprising a dielectric of a third material that exhibits a thermal conductivity which exceeds a required third thermal conductivity threshold when operating in the temperature range, anc
a pair of plates having an electrical conductivity of greater than a second threshold electrical conductivity when operating ir the temperature range.

6. The hybrid microwave attenuator of any of the preceding claims, the dispersive component further comprising:
a substrate formed of a fourth material that exhibits a thermal conductivity of greater than a fourth threshold thermal conductivity when operating in the temperature range.

7. The hybrid microwave attenuator of any of the preceding claims, wherein each connector (908, 910) in the pair of connectors is of an identical gender.

8. The hybrid microwave attenuator of any of the preceding claims, wherein each connector (908, 910) in the pair of connectors is coupled to a port (Port 1, Port 2) from the two ports of the circuit.

9. The hybrid microwave attenuator of any of the preceding claims, wherein the pair of connectors is formed of a fifth material that exhibits a thermal conductivity of greater than a fifth threshold thermal conductivity when operating ir the temperature range.

10. A method comprising:
forming a hybrid microwave attenuator by assembling a circuit having two ports, the circuit comprising:
a resistive component (302) configured to attenuate a plurality of frequencies in an input signal, and
a dispersive component (304, 306, 404, 406, 604, 704) configured to attenuate a second plurality of frequencies within a frequency range, wherein the resistive component and the dispersive component are arranged in a series configuration relative to one another between the two ports of the circuit, **characterized in that**:
the dispersive component comprising an inductive element (L2, L3, L6) configured to provide an electrical-thermal path between a center conductor of the hybrid microwave attenuator and a ground of the hybrid microwave attenuator, the inductive element being formed of a first material that exhibits at a least a first threshold level of thermal conductivity, wherein the first threshold level of thermal conductivity is achieved
at a cryogenic temperature range in which a quantum circuit operates, and forming a housing (900), the housing comprising:
a closable structure (902, 904, 906) in which the circuit is positioned, the structure being formed of a second material that exhibits at least a second threshold level of thermal conductivity, wherein the second threshold level of thermal conductivity is achieved at the cryogenic temperature range; and
a pair of microwave connectors (908, 910), the pair of connectors thermally coupled to the housing.

11. The method of claim 10 , wherein the hybrid microwave attenuator is configured to operate in a temperature range of a refrigeration stage, wherein the inductive element (L2, L3, L6) is formed of a first material that exhibits an electrical conductivity of greater than a first threshold electrical conductivity when operating in the temperature range.

12. The method of claim 11, wherein the temperature range is bound by 300 degrees Kelvin, K, and 2 K.

13. The method of claim 11, wherein the temperature range is bound by 2 K and 0.000001 K.

14. The method of any of claims 10 to 13, wherein the hybrid microwave attenuator is configured to operate in a temperature range of a refrigeration stage, the dispersive component further comprising a capacitive element (C1, C2, C3, C4, C5, C6) comprising a dielectric of a third material that exhibits a thermal conductivity which exceeds a predetermined third thermal conductivity threshold when operating in the temperature range, and a pair of plates having an electrical conductivity of greater than a second threshold electrical conductivity wher operating in the temperature range.

## Patentansprüche

1. Hybridmikrowellendämpfer, der zum Betrieb in einem Temperaturbereich einer Kühlstufe ausgelegt ist, wobei der Dämpfer umfasst:
eine Schaltung, die zwei Anschlüsse (Anschluss 1, Anschluss 2) aufweist, wobei die Schaltung umfasst:
eine Widerstandskomponente (302), die zum Dämpfen einer Vielzahl von Frequenzen in einem Eingangssignal ausgelegt ist, und
eine Dispersionskomponente (304, 306, 404, 406, 604, 704), die zum Dämpfen einer zweiten Vielzahl von Frequenzen innerhalb eines Frequenzbereichs ausgelegt ist, wobei die Widerstandskomponente und die Dispersionskomponente in einer Reihenanordnung im Verhältnis zueinander zwischen den zwei Anschlüssen der Schaltung angeordnet sind, **dadurch gekennzeichnet, dass**:
die Dispersionskomponente ein induktives Element (L2, L3, L6) umfasst, das zum Bereitstellen eines elektrisch-thermischen Pfads zwischen einem zentralen Leiter des Hybridmikrowellendämpfers und einer Masse des Hybridmikrowellendämpfers ausgelegt ist, wobei das induktive Element aus einem ersten Material gebildet ist, das mindestens einen ersten Wärmeleitfähigkeitsschwellenwert aufweist, wobei der erste Wärmeleitfähigkeitsschwellenwert bei einem Tieftemperaturbereich erreicht wird, in dem eine Quantenschaltung arbeitet; und
ein Gehäuse (900), wobei das Gehäuse umfasst:
eine verschließbare Struktur (902, 904, 906), in der die Schaltung positioniert ist, wobei die Struktur aus einem zweiten Material gebildet ist, das mindestens einen zweiten Wärmeleitfähigkeitsschwellenwert aufweist, wobei der zweite Wärmeleitfähigkeitsschwellenwert bei dem Tieftemperaturbereich erreicht wird; und
ein Paar Mikrowellenverbinder (908, 910), wobei das Paar Verbinder thermisch an das Gehäuse gekoppelt ist.

2. Hybridmikrowellendämpfer nach Anspruch 1, wobei das induktive Element (L2, L3, L6) aus dem ersten Material gebildet ist, das eine elektrische Leitfähigkeit aufweist, die größer als eine erste Schwelle elektrischer Leitfähigkeit beim Betrieb im Temperaturbereich ist.

3. Hybridmikrowellendämpfer nach Anspruch 2, wobei der Temperaturbereich durch 300 Grad Kelvin, K, und 2 K gebunden ist.

4. Hybridmikrowellendämpfer nach Anspruch 2, wobei der Temperaturbereich durch 2 K und 0,000001 K gebunden ist.

5. Hybridmikrowellendämpfer nach einem der vorstehenden Ansprüche, wobei die Dispersionskomponente weiter umfasst:
ein kapazitives Element (C1, C2, C3, C4, C5, C6), umfassend ein Dielektrikum aus einem dritten Material, das eine Wärmeleitfähigkeit aufweist, die eine erforderliche dritte Wärmeleitfähigkeitsschwelle beim Betrieb im Temperaturbereich überschreitet, und
ein Paar Platten, die eine elektrische Leitfähigkeit aufweisen, die größer als eine zweite Schwelle elektrischer Leitfähigkeit beim Betrieb im Temperaturbereich ist.

6. Hybridmikrowellendämpfer nach einem der vorstehenden Ansprüche, wobei die Dispersionskomponente weiter umfasst:
ein Substrat, das aus einem vierten Material gebildet ist, das eine Wärmeleitfähigkeit aufweist, die größer als eine vierte Wärmeleitfähigkeitsschwelle beim Betrieb im Temperaturbereich ist.

7. Hybridmikrowellendämpfer nach einem der vorstehenden Ansprüche, wobei jeder Verbinder (908, 910) im Paar Verbinder von einem gleichen Geschlecht ist.

8. Hybridmikrowellendämpfer nach einem der vorstehenden Ansprüche, wobei jeder Verbinder (908, 910) im Paar Verbinder an einen Anschluss (Anschluss 1, Anschluss 2) von den zwei Anschlüssen der Schaltung gekoppelt ist.

9. Hybridmikrowellendämpfer nach einem der vorstehenden Ansprüche, wobei das Paar Verbinder aus einem fünften Material gebildet ist, das eine Wärmeleitfähigkeit aufweist, die größer als eine fünfte Wärmeleitfähigkeitsschwelle beim Betrieb im Temperaturbereich ist.

10. Verfahren, umfassend:
Bilden eines Hybridmikrowellendämpfers durch Zusammenbauen einer Schaltung mit zwei Anschlüssen, wobei die Schaltung umfasst:
eine Widerstandskomponente (302), die zum Dämpfen einer Vielzahl von Frequenzen in einem Eingangssignal ausgelegt ist, und
eine Dispersionskomponente (304, 306, 404, 406, 604, 704), die zum Dämpfen einer zweiten Vielzahl von Frequenzen innerhalb eines Frequenzbereichs ausgelegt ist, wobei die Widerstandskomponente und die Dispersionskomponente in einer Reihenanordnung im Verhältnis zueinander zwischen den zwei Anschlüssen der Schaltung angeordnet sind, **dadurch gekennzeichnet, dass**:
die Dispersionskomponente ein induktives Element (L2, L3, L6) umfasst, das zum Bereitstellen eines elektrisch-thermischen Pfads zwischen einem zentralen Leiter des Hybridmikrowellendämpfers und einer Masse des Hybridmikrowellendämpfers ausgelegt ist, wobei das induktive Element aus einem ersten Material gebildet ist, das mindestens einen ersten Wärmeleitfähigkeitsschwellenwert aufweist, wobei der erste Wärmeleitfähigkeitsschwellenwert bei einem Tieftemperaturbereich erreicht wird, in dem eine Quantenschaltung arbeitet; und
ein Gehäuse (900), wobei das Gehäuse umfasst:
eine verschließbare Struktur (902, 904, 906), in der die Schaltung positioniert ist, wobei die Struktur aus einem zweiten Material gebildet ist, das mindestens einen zweiten Wärmeleitfähigkeitsschwellenwert aufweist, wobei der zweite Wärmeleitfähigkeitsschwellenwert bei dem Tieftemperaturbereich erreicht wird; und
ein Paar Mikrowellenverbinder (908, 910), wobei das Paar Verbinder thermisch an das Gehäuse gekoppelt ist.

11. Verfahren nach Anspruch 10, wobei der Hybridmikrowellendämpfer zum Betrieb in einem Temperaturbereich einer Kühlstufe ausgelegt ist, wobei das induktive Element (L2, L3, L6) aus einem ersten Material gebildet ist, das eine elektrische Leitfähigkeit aufweist, die größer als eine erste Schwelle elektrischer Leitfähigkeit beim Betrieb im Temperaturbereich ist.

12. Verfahren nach Anspruch 11, wobei der Temperaturbereich durch 300 Grad Kelvin, K, und 2 K gebunden ist.

13. Verfahren nach Anspruch 11, wobei der Temperaturbereich durch 2 K und 0,000001 K gebunden ist.

14. Verfahren nach einem der Ansprüche 10 bis 13, wobei der Hybridmikrowellendämpfer zum Betrieb in einem Temperaturbereich einer Kühlstufe ausgelegt ist, wobei die Dispersionskomponente weiter umfasst
ein kapazitives Element (C1, C2, C3, C4, C5, C6), umfassend ein Dielektrikum aus einem dritten Material, das eine Wärmeleitfähigkeit aufweist, die eine vorbestimmte dritte Wärmeleitfähigkeitsschwelle beim Betrieb im Temperaturbereich überschreitet, und ein Paar Platten, die eine elektrische Leitfähigkeit aufweisen, die größer als eine zweite Schwelle elektrischer Leitfähigkeit beim Betrieb im Temperaturbereich ist.

## Revendications

1. Atténuateur de micro-ondes hybride configuré pour fonctionner dans une plage de températures d'un étage de réfrigération, l'atténuateur comprenant :
un circuit présentant deux ports (Port 1, Port 2), le circuit comprenant :
un composant résistif (302) configuré pour atténuer une pluralité de fréquences dans un signal d'entrée, et
un composant dispersif (304, 306, 404, 406, 604, 704) configuré pour atténuer une seconde pluralité de fréquences à l'intérieur d'une plage de fréquences, dans lequel le composant résistif et le composant dispersif sont agencés dans une configuration en série l'un avec l'autre entre les deux ports du circuit, **caractérisé en ce que** :
le composant dispersif comprenant un élément inductif (L2, L3, L6) configuré pour fournir un trajet électrique-thermique entre un conducteur central de l'atténuateur de micro-ondes hybride et une masse de l'atténuateur de micro-ondes hybride, l'élément inductif étant constitué d'un premier matériau qui présente au moins un premier niveau de seuil de conductivité thermique, dans lequel le premier niveau de seuil de conductivité thermique est atteint à une plage de températures cryogéniques dans laquelle un circuit quantique fonctionne ; et
un logement (900), le logement comprenant :
une structure refermable (902, 904, 906) dans laquelle le circuit est positionné, la structure étant constituée d'un deuxième matériau qui présente au moins un deuxième niveau de seuil de conductivité thermique, dans lequel le deuxième niveau de seuil de conductivité thermique est atteint à la plage de températures cryogéniques ; et
une paire de connecteurs à micro-ondes (908, 910), la paire de connecteurs étant couplée thermiquement au logement.

2. Atténuateur de micro-ondes hybride selon la revendication 1, dans lequel l'élément inductif (L2, L3, L6) est constitué du premier matériau qui présente une conductivité électrique supérieure à un premier seuil de conductivité électrique lors du fonctionnement dans la plage de températures.

3. Atténuateur de micro-ondes hybride selon la revendication 2, dans lequel la plage de températures est délimitée par 300 degrés Kelvin, K, et 2 K.

4. Atténuateur de micro-ondes hybride selon la revendication 2, dans lequel la plage de températures est délimitée par 2 K et 0,000001 K.

5. Atténuateur de micro-ondes hybride selon l'une quelconque des revendications précédentes, le composant dispersif comprenant en outre :
un élément capacitif (C1, C2, C3, C4, C5, C6) comprenant un diélectrique d'un troisième matériau qui présente une conductivité thermique qui dépasse un troisième seuil de conductivité thermique requis lors du fonctionnement dans la plage de températures, et
une paire de plaques présentant une conductivité électrique supérieure à un second seuil de conductivité électrique lors du fonctionnement dans la plage de températures.

6. Atténuateur de micro-ondes hybride selon l'une quelconque des revendications précédentes, le composant dispersif comprenant en outre :
un substrat constitué d'un quatrième matériau qui présente une conductivité thermique supérieure à un quatrième seuil de conductivité thermique lors du fonctionnement dans la plage de températures.

7. Atténuateur de micro-ondes hybride selon l'une quelconque des revendications précédentes, dans lequel chaque connecteur (908, 910) dans la paire de connecteurs est d'un genre identique.

8. Atténuateur de micro-ondes hybride selon l'une quelconque des revendications précédentes, dans lequel chaque connecteur (908, 910) dans la paire de connecteurs est couplé à un port (Port 1, Port 2) parmi les deux ports du circuit.

9. Atténuateur de micro-ondes hybride selon l'une quelconque des revendications précédentes, dans lequel la paire de connecteurs est constituée d'un cinquième matériau qui présente une conductivité thermique supérieure à un cinquième seuil de conductivité thermique lors du fonctionnement dans la plage de températures.

10. Procédé comprenant :
la constitution d'un atténuateur de micro-ondes hybride par l'assemblage d'un circuit présentant deux ports, le circuit comprenant :
un composant résistif (302) configuré pour atténuer une pluralité de fréquences dans un signal d'entrée, et
un composant dispersif (304, 306, 404, 406, 604, 704) configuré pour atténuer une seconde pluralité de fréquences à l'intérieur d'une plage de fréquences, dans lequel le composant résistif et le composant dispersif sont agencés dans une configuration en série l'un avec l'autre entre les deux ports du circuit, **caractérisé en ce que** :
le composant dispersif comprenant un élément inductif (L2, L3, L6) configuré pour fournir un trajet électrique-thermique entre un conducteur central de l'atténuateur de micro-ondes hybride et une masse de l'atténuateur de micro-ondes hybride, l'élément inductif étant constitué d'un premier matériau qui présente au moins un premier niveau de seuil de conductivité thermique, dans lequel le premier niveau de seuil de conductivité thermique est atteint à une plage de températures cryogéniques dans laquelle un circuit quantique fonctionne, et
la constitution d'un logement (900), le logement comprenant :
une structure refermable (902, 904, 906) dans laquelle le circuit est positionné, la structure étant constituée d'un deuxième matériau qui présente au moins un deuxième niveau de seuil de conductivité thermique, dans lequel le deuxième niveau de seuil de conductivité thermique est atteint à la plage de températures cryogéniques ; et
une paire de connecteurs à micro-ondes (908, 910), la paire de connecteurs étant couplée thermiquement au logement.

11. Procédé selon la revendication 10, dans lequel l'atténuateur de micro-ondes hybride est configuré pour fonctionner dans une plage de températures d'un étage de réfrigération, dans lequel l'élément inductif (L2, L3, L6) est constitué d'un premier matériau qui présente une conductivité électrique supérieure à un premier seuil de conductivité électrique lors du fonctionnement dans la plage de températures.

12. Procédé selon la revendication 11, dans lequel la plage de températures est délimitée par 300 degrés Kelvin, K, et 2 K.

13. Procédé selon la revendication 11, dans lequel la plage de températures est délimitée par 2 K et 0,000001 K.

14. Procédé selon l'une quelconque des revendications 10 à 13, dans lequel l'atténuateur de micro-ondes hybride est configuré pour fonctionner dans une plage de températures d'un étage de réfrigération, le composant dispersif comprenant en outre
un élément capacitif (C1, C2, C3, C4, C5, C6) comprenant un diélectrique d'un troisième matériau qui présente une conductivité thermique qui dépasse un troisième seuil de conductivité thermique prédéterminé lors du fonctionnement dans la plage de températures, et une paire de plaques présentant une conductivité électrique supérieure à un second seuil de conductivité électrique lors du fonctionnement dans la plage de températures.
